# EUROPEAN PATENT APPLICATION

(11) **EP 1 746 657 A2**
(43) Date of publication of application: **24.01.2007**
(21) Application number: 06253653.7
(22) Date of filing: 12.07.2006
(51) Int. Cl.: H01L 27/146

(54) **Method for making image sensor with reduced etching damage**

(30) Priority: 18.07.2005 US 184186
(71) Applicant: OmniVision Technologies, Inc., Sunnyvale, California 94089 (US)
(72) Inventor: Rhodes, Howard E., Boise, Idaho 83706 (US)
(74) Representative: Hackney, Nigel John

(57) **Abstract**

A method of forming a pixel of an image sensor with reduced etching damage is disclosed. The method first includes forming a light sensitive element in a substrate. Then, a transfer gate is formed atop the substrate and adjacent to the light sensitive element. A protective layer, such as an anti-reflective coating, is then formed over the light sensitive element. A blanket oxide layer is formed over the protective layer and the transfer gate. Finally, the oxide layer is etched back to form a sidewall spacer the sidewall of a gate stack. The protective layer protects the surface of the light sensitive element from etching damage.

## Description

The present invention relates to the manufacture of image sensors, and more particularly, to a process that reduces the amount of etching damage done to a photodiode during the manufacturing process.

Image sensors have become ubiquitous. They are widely used in digital still cameras, cellular phones, security cameras, medical, automobile, and other applications. The technology used to manufacture image sensors, and in particular CMOS image sensors, has continued to advance at great pace. For example, the demands of higher resolution and lower power consumption have encouraged the further miniaturization and integration of the image sensor.

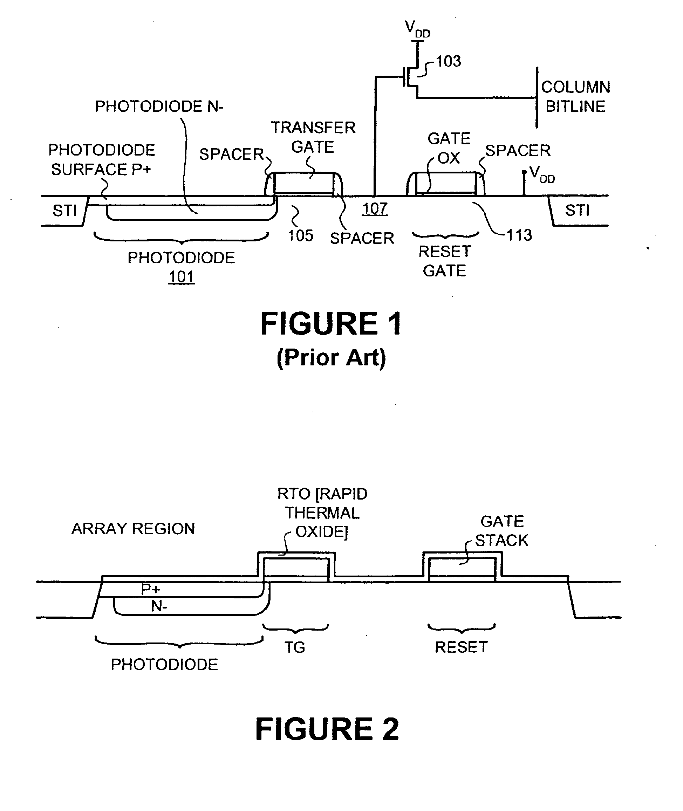

The manufacture of high performance image sensors is a complicated process with many process steps. For example, to form the photodiode and other components of an active pixel of an image sensor, various etching, implantation, photolithography, and cleaning steps must be carried out. One common step used in the manufacture of a pixel is an etching step to form sidewall spacers on the sidewalls of transistor control gates, as seen in Figure 1. This is sometimes referred to as a blanket spacer etch or simply spacer etch. One difficulty with this process is that the surface of the photodiode (formed from silicon) can sustain damage due to the etching process. Further, contamination of the silicon surface at the photodiode with heavy metals may also occur, typically during subsequent cleaning steps. Silicon is known to be a "getter" of heavy metal impurities from a liquid bath. Moreover, the silicon surface at the photodiode will be roughened by over etching during a typical spacer etch process.

Other attempts to solve this issue center around the use of masking during the spacer etch. In this solution, both the N⁺ spacer etch and the P⁺ spacer etch must be masked. This gives rise to several drawbacks. First, there are now two spacer etches that must be used adding increased cost and complexity.

Furthermore, with the use of a photoresist during the etch, there is a polymer created during the spacer etch that redeposits on the surface of the wafer that can interfere with the spacer etch. This is especially true as device technology shrinks and the gates of the transistors are placed closer together. The polymer can deposit even between tight gate features and block the formation of a spacer. Thus, the use of two photoresist masks exacerbates this issue.

Further, the design of the mask at the interface between the N-channel transistors (within the P-well) and the P-channel transistors (within the N-well) must be carefully designed. The N-channel transistor sidewall spacer etch, and the mask used for that step, must extend into the P-well. Similarly, the mask for the P-channel transistors must also extend into the N-well to prevent the N-well/P-well interface from seeing a double spacer etch which may cut deeply into the field oxide. This process of extending the mask into the opposite well may create a "hedge" that is undesirable.

In general, the present invention provides a new spacer etch process that minimizes damage to the sensor photodiode surface.

Accordingly, in a first aspect, the present invention provides a method and image sensor according to claims 1 and 15 respectively.

### BRIEF DESCRIPTION OF THE DRAWINGS

Figure 1 is a combination cross-sectional and schematic diagram of a prior art four transistor (4T) pixel which shows in detail a photodiode formed in a substrate.
Figures 2-6 are cross sectional views illustrating the process of manufacturing a pixel in accordance with the present invention.
Figures 7-8 illustrate alternative embodiments of the present invention.

### DETAILED DESCRIPTION

In the following description, numerous specific details are provided in order to give a thorough understanding of embodiments of the invention. One skilled in the relevant art will recognize, however, that the invention may be practiced without one or more of the specific details, or with other methods, components, materials, etc. In other instances, well known structures, materials, or operations are not shown or described in order to avoid obscuring aspects of the invention.
Referenced throughout the specification to "one embodiment" or "an embodiment" means that a particular feature, structure, or characteristic described in connection with the embodiment and included in at least one embodiment of the present invention. Thus, the appearances of the phrase "in one embodiment" or "in an embodiment" in various places throughout the specification are not necessarily all referring to the same embodiment. Furthermore, the particular features, structures, or characteristics may be combined in any suitable manner in one or more embodiments.
Figure 1 shows a combination cross-sectional and schematic view of an active pixel that uses four transistors. This is known in the art as a 4T active pixel. A light-sensing element, in this embodiment a photodiode 101, outputs a signal that is used to modulate an amplification transistor 103. The amplification transistor 103 is also referred to as a source follower transistor. While the light-sensing element can be one of a variety of devices, including without limitation, photogates, photodiodes, pinned photodiodes, partially pinned photodiodes, etc., in the present invention, the light-sensing element is a photodiode (whether of the pinned, partially pinned, or unpinned variety). A transfer transistor 105 is used to transfer the signal output by the photodiode 101 to a floating node 107, which is connected to the gate of the amplification transistor 103. The transfer transistor 105 is controlled by a transfer gate.
While the description herein is in the context of a 4T pixel, it is to be understood that this invention applies to all CMOS imagers whether they be formed with 3, 4, 5, 6, or more transistors. This invention also applies to CCD image sensors.
In operation, during an integration period (also referred to as an exposure or accumulation period), the photodiode 101 generates charge that is held in the N-type layer. After the integration period, the transfer transistor 105 is turned on to transfer the charge held in the N-type layer of the photodiode 101 to the floating node 107. After the signal has been transferred to the floating node 107, the transfer transistor 105 is turned off again for the start of a subsequent integration period.
The signal on the floating node 107 is then used to modulate the amplification transistor 103. Finally, the signal from the amplification transistor 103 is read out signal onto a column bit line 111. After readout through the column bit line 111, a reset transistor 113 resets the floating node 107 to a reference voltage. In one embodiment, the reference voltage is V_{dd}.

Turning to Figure 2, there is shown a single pixel with a photodiode region, transfer transistor with a transfer gate (TG), and a reset transistor (reset). Further, formed a top of the gates of the transfer transistor and the reset transistor is a gate stack (typically a conductor and a gate oxide). An insulator oxide layer is formed, such as by a rapid thermal process, to form a RTO (rapid thermal oxide) layer. In one embodiment, the RTO layer is between 20 and 100 angstroms thick. The insulator oxide layer (also known as a buffer layer) may be alternatively a deposited oxide or a furnace grown oxide.

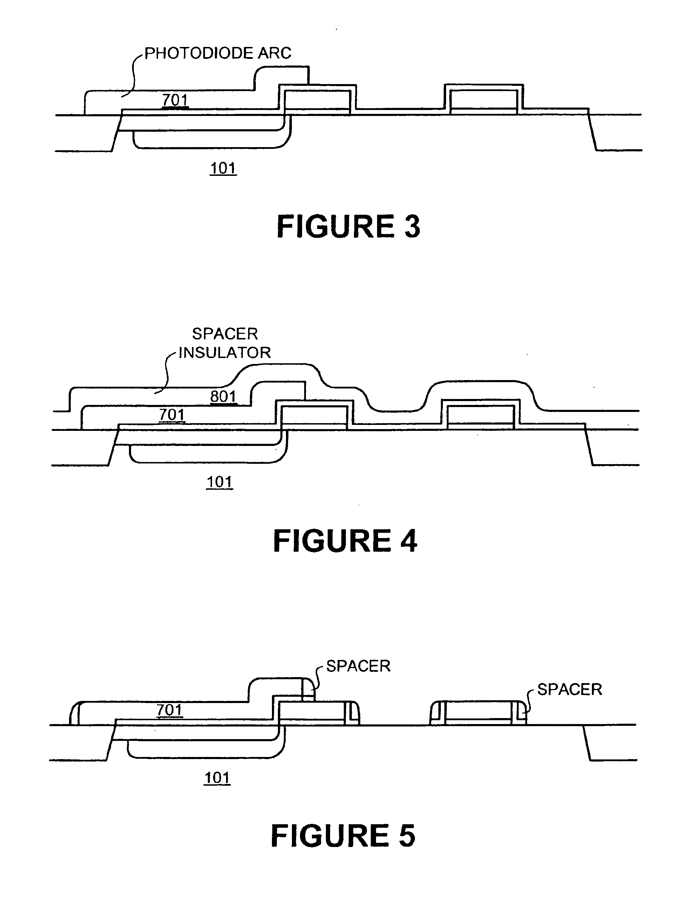

Note that the gate stack can take various forms and still be consistent with the present claimed invention. For example, the gate dielectric may be a grown silicon dioxide layer or a hardened gate oxide or a high dielectric constant (high K) material such as hafnium oxide, tantalum oxide, or the like. The gate conductor is typically polysilicon and may be N⁺ doped polysilicon or P⁺ doped polysilicon. In other embodiments, the conductor may be a metal. It is also possible for there to be an insulator over the gate conductor. The insulator could be an oxide, an oxynitride, or a silicon nitride, or any combination thereof. For simplicity, we show in Figure 2 a simple gate stack which is a grown silicon dioxide layer under a doped polysilicon conductor.
The photodiode region has a P+ pinning layer and a buried N- implant. Note that for clarity, not all implants are shown. For example, there may be well implants, threshold voltage adjustment implants, transistor lightly doped drain (LDD) implants, and transistor halo implants. All of these implants are well known implants and to avoid obscuration of the invention, these implants are not shown in the Figures.
Turning to Figure 3 an anti-reflective coating (ARC) 701 is deposited and patterned to cover the photodiode 101. In general, it has been found that the photodiode ARC 701 should be transparent to light in the visible spectrum. In one embodiment, the ARC is silicon nitride (Si₃N₄). It should be noted that other types of anti-reflective coatings may also be suitable, such as those commercially available from Brewer Science of Rolla, MO. Thus, the use of silicon nitride is but one example of a suitable anti-reflective coating. For example, the ARC may be silicon oxynitride (SiOₓN_{y}) or a multilayer stack, such as SiO₂/Si₃N₄, SiOₓN_{y}/Si₃N₄, or SiOₓN_{y}/Si₃N₄/SiO_{w}N_{z}. Alternatively, a graded stack such as SiOₓN_{y}/Si₃O_{c}N_{w}/SiO_{q}/Nᵤ may be used.
The underlying oxide layer (RTO or furnace oxide or insulator) acts as a stop layer when the ARC layer 701 is patterned and etched. This prevents damage to the source/drain regions when the ARC layer 701 in the case where the ARC layer 701 is overetched. The underlying insulator also can act as a buffer layer to minimize stress between the ARC layer 701 and the silicon.
Furthermore, the thickness of the silicon nitride anti-reflective coating layer 701 should be chosen to be appropriate to eliminate reflections near the incident wavelengths that are being detected. For an image sensor that is designed to be sensitive to visible radiation, the thickness of the silicon nitride layer may be approximately 550 Angstroms. More broadly stated for the visible spectrum, the thickness for the anti-reflective coating 701 formed of silicon nitride is approximately between 200-1000 angstroms. In some embodiments, the thickness of the ARC layer 701 is between 400-800 angstroms.
While the described embodiment herein teaches the use of a silicon nitride anti-reflective coating atop of the photodiode silicon surface and separated by some type of buffering layer (the RTO layer), the present invention may be construed more broadly to eliminate the buffer layer.

Turning next to Figure 4, a spacer insulator layer 801 is deposited over the antireflective coating 701 and the remainder of the pixel in a blanket fashion. The spacer insulator layer 801 may be an oxide in one embodiment. In other embodiments, the insulator layer may be an oxide, a nitride, an oxynitride, or a combination thereof.

Next, turning to Figure 5, a blanket spacer etch is done with an antisotropic etch that is selective to the ARC layer 701. This will form sidewalls on the ARC layer 701 as well as on the side walls of the transistor control gates. Note that in Figure 5, the photodiode 101 is protected and the surface silicon of the photodiode is not etched by the spacer etch. Further, this solution does not require two spacer etching processes.

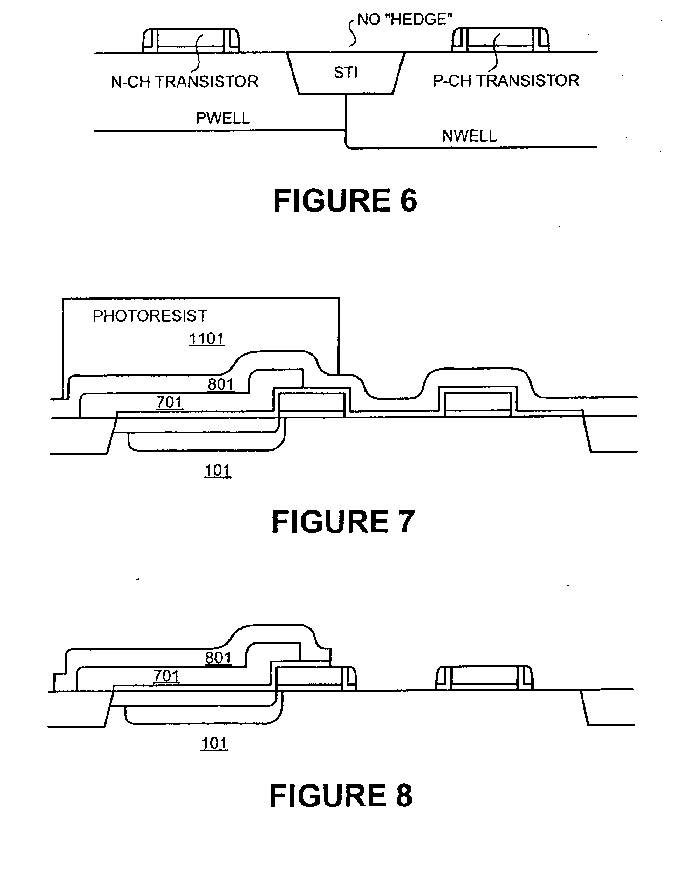

Turning to Figure 6, the use of the method shown in the present invention also eliminates the "hedge" at the shallow trench isolation (STI) between the P-Well and the N-Well. Note that while the above description is in the context of forming a transfer gate, the invention can also be used in connection with the formation of other gates used in image sensors, such as a reset gate, a high dynamic range gate, or a lateral overflow drain gate

Alternatively, as seen in Figure 7, a photoresist layer 1101 can be further patterned above the photodiode 101 and the ARC layer 701. The photoresist 1101 provides further protection and the spacer etch is then done with this protective photoresist 1101 in place. This eliminates the requirement that the spacer etch be selective to the buried ARC layer 701. Figure 8 shows the cross section after the etching and removal of the photo resist layer 1101.
From the foregoing, it will be appreciated that specific embodiments of the invention have been described herein for purposes of illustration, but that various modifications may be made without deviating from the spirit and scope of the invention. For example, it may be possible to use the concepts of the present invention with NPN pinned photodiodes, where the dopant types are switched from that shown in the Figures. Accordingly, the invention is not limited except as by the appended claims.

## Claims

1. A method of comprising:
forming a light sensitive element in a substrate;
forming a gate atop said substrate and adjacent said light sensitive element;
forming a protective layer over said light sensitive element;
forming an insulating layer over said protective layer and said gate; and
etching back said insulating layer to form a sidewall spacer the sidewall of a gate stack.

2. The method of Claim 1 wherein said gate is a transfer gate, a reset gate; a high dynamic range gate, or a lateral overflow drain gate.

3. The method of Claim 1 wherein said insulating layer is an oxide layer.

4. The method of Claim 1 wherein said protective layer is an anti-reflective coating.

5. The method of Claim 4 wherein said protective layer is patterned and etched so that it remains over said light sensitive element.

6. The method of Claim 1 further including forming a buffer layer between said protective layer and said light sensitive element.

7. The method of Claim 6 wherein said buffer layer is chosen from the group of a rapid thermal oxide layer, a deposited oxide, or a furnace grown oxide.

8. The method of Claim 1 wherein said light sensing element is a photodiode or a photogate.

9. The method of Claim 8 wherein said photodiode has a P+ pinning layer on the surface of said substrate.

10. The method of Claim 7 wherein said buffer layer has a thickness of between 20 to 100 angstroms.

11. The method of Claim 4 wherein the anti-reflective coating has a thickness of between 400-800 angstroms thick.

12. The method of Claim 1 further including forming a photoresist layer over said oxide layer prior to etching back, said photoresist layer patterned to be over said light sensitive element.

13. The method of Claim 1 wherein said insulating layer is an oxide, a nitride, an oxynitride, or a combination thereof.

14. The method of Claim 1 wherein said protective layer is deposited first, said insulating layer is then deposited, and then said etch is performed subsequently using an anisotropic etch.

15. A CMOS image sensor using pixels that are formed by:
forming a light sensitive element in a substrate;
forming a gate atop said substrate and adjacent said light sensitive element;
forming a protective layer over said light sensitive element;
forming an insulating layer over said protective layer and said gate; and
etching back said insulating layer to form a sidewall spacer the sidewall of a gate stack.

16. The image sensor of Claim 15 wherein said gate is a transfer gate, a reset gate, a high dynamic range gate, or a lateral overflow drain gate.

17. The image sensor of Claim 15 wherein said protective layer is an anti-reflective coating.

18. The image sensor of Claim 17 wherein said protective layer is patterned and etched so that it remains over said light sensitive element.

19. The image sensor of Claim 15 further including forming a buffer layer between said protective layer and said light sensitive element.

20. The image sensor of Claim 19 wherein said buffer layer has a thickness of between 20 to 100 angstroms.

21. The image sensor of Claim 17 wherein the anti-reflective coating has a thickness of between 400-800 angstroms thick.

22. The image sensor of Claim 15 further including forming a photoresist layer over said oxide layer prior to etching back, said photoresist layer patterned to be over said light sensitive element.
